# EUROPÄISCHE PATENTSCHRIFT

(11) **EP 1 678 351 B1**
(45) Veröffentlichungstag und Bekanntmachung des Hinweises auf die Patenterteilung: **26.09.2007**
(21) Anmeldenummer: 04789982.8
(22) Anmeldetag: 14.10.2004
(51) Int. Cl.: C25D 5/02, C23C 18/16, B05D 1/32

(54) **VERFAHREN UND SYSTEM ZUM SELEKTIVEN BESCHICHTEN VON METALLOBERFLAECHEN**
METHOD AND SYSTEM FOR SELECTIVELY COATING METAL SURFACES
PROCEDE ET SYSTEME POUR REVETIR SELECTIVEMENT DES SURFACES METALLIQUES

(30) Priorität: 16.10.2003 DE 10348734
(43) Veröffentlichungstag der Anmeldung: 12.07.2006
(73) Patentinhaber: OTB Oberflächentechnik in Berlin GmbH & Co., 12277 Berlin (DE)
(72) Erfinder: LANDAU, Uwe, 14169 Berlin (DE); WIEDENBECK, Rainer, 15827 Blankenfelde (DE)
(74) Vertreter: Tilger, Bernhard
(86) Internationale Anmeldenummer: PCT/DE2004/002280
(87) Internationale Veröffentlichungsnummer: WO 2005/040461

(56) Entgegenhaltungen:
- EP-A- 1 111 090
- CA-A1- 2 272 195
- US-A- 4 643 912
- US-A- 5 201 946
- US-A- 6 117 485
- US-A1- 2002 150 843
- PATENT ABSTRACTS OF JAPAN Bd. 012, Nr. 426 (C-542), 10. November 1988 (1988-11-10) & JP 63 157876 A (TOOBI:KK; others: 01), 30. Juni 1988 (1988-06-30)

## Beschreibung

Die vorliegende Erfindung betrifft ein Verfahren und ein System zum selektiven galvanischen Beschichten von Metalloberflächen.

Das selektive Beschichten oder Belacken von Metalloberflächen ist insbesondere bei der Herstellung elektrischer oder elektronischer Bauteile von großer Bedeutung, wo es zum Maskieren nicht zu bearbeitender Oberflächenbereiche bei den erforderlichen selektiven Galvanisierungsschritten verwendet wird.

Im einfachsten Fall wird das Metall durch kontrolliertes partielles Eintauchen in ein geeignetes Dielektrikum oder einen geeigneten Lack kantenumgreifend beschichtet Hiermit sind auf der Oberfläche jedoch keine Streifen, Spots oder sonstige Strukturen herstellbar. Die Beschichtung kann beispielsweise auch mittels einer geeigneten Druck-, Spritz-, Sprüh- oder Streicheinrichtung selektiv aufgedruckt, aufgespritzt, aufgesprüht oder aufgestrichen werden. Hierbei kommt es jedoch häufig zu sehr unerwünschten nachteiligen Lackspritzem oder Lackbenetzungen im Kontaktbereich, das sogenannte "Overspray", die sich bei herkömmlichen selektiven Lackauftragungsverfahren kaum vermeiden lassen und ein großes Handicap dieser Verfahren darstellen. Zum Schutz können die nicht zu beschichtenden Oberflächenbereiche hierbei auch zunächst durch eine geeignete Maskierung, wie z.B. eine dünne Maske aus Kunststoff oder Metall, abgedeckt werden, die nach dem Beschichten der nicht maskierten Bereiche wieder entfernt wird.

Die EP 1 111 090 A2 offenbart ein Verfahren zum selektiven galvanischen Beschichten oder Plattieren einer nichtmetallischen Unterlage. Die Unterlage, die beispielsweise aus einem Kunstharz oder dergleichen oder aber auch aus einem anorganischen Material, wie z.B. Keramik oder Glas bestehen kann, wird hierbei zunächst durch Formpressen, insbesondere Spritzgießen, mit einer Maskierung aus einem wasserlöslichen oder hydrolysierbaren Polymer versehen und dann durch einfaches Eintauchen in eine entsprechende Lösung mit einem geeigneten Galvanisierungskatalysator, wie z.B. Palladium oder Titan, beschichtet. Der Galvanisierungskatalysator kann jedoch gegebenenfalls auch bereits vor der Maskierung oder gleichzeitig mit dieser aufgebracht werden. Die katalytisch beschichteten freien Oberflächenbereiche werden nun mit der gewünschten galvanischen Beschichtung versehen, während die aufgebrachte Maskierung mit Wasser wieder abgelöst wird.

Die GB 1 359 595 A offenbart ein Verfahren zum selektiven galvanischen Beschichten von Achslagern für Eisenbahnfahrzeuge, bei dem zunächst die nicht zu beschichtenden Oberflächenbereiche selektiv mit Lack maskiert werden. Anschließend wird die gesamte Oberfläche durch einfaches Eintauchen in flüssiges Wachs mit einer Wachsschicht versehen, die dann jedoch von dem galvanisch zu beschichtenden Oberflächenbereich wieder mechanisch entfernt wird, während auf den nicht galvanisch zu beschichtenden Oberflächenbereichen eine Doppelmaskierung aus Lack und Wachs verbleibt. Die nicht mehr mit einer Wachsschicht bedeckten freien Oberflächenbereiche der Achslager werden dann zunächst durch mehrfaches Eintauchen in eine Zinkatlösung mit einer Zinkschicht versehen und anschließend galvanisch beschichtet.

Die US 5 190 486 A offenbart ein Verfahren und eine Vorrichtung zum selektiven galvanischen Beschichten von Pins oder Anschlußstiften mit Gold. Die Endbereiche dieser Pins können hierbei durch einfaches Eintauchen in eine geeignete Lösung elektrophoretisch mit einem geeigneten Resist maskiert werden.

Die Aufgabe der vorliegenden Erfindung besteht in der Schaffung eines möglichst einfachen, flexiblen, präzisen und kostengünstigen neuartigen galvanischen Selektiv-Beschichtungsverfahrens für Metalloberflächen. Das gesuchte galvanische Selektiv-Beschichtungsverfahren soll insbesondere ein besseres Maskieren der nicht galvanisch zu beschichtenden Oberflächenbereiche ermöglichen. Die Aufgabe besteht auch in der Schaffung eines galvanischen Selektiv-Beschichtungssystems zur Durchführung dieses Verfahrens.

Diese Aufgabe wird erfindungsgemäß durch ein galvanisches Selektiv-Beschichtungsverfahren gemäß Anspruch 1 bzw. ein galvanisches Selektiv-Beschichtungssystem nach Anspruch 15 gelöst. Bevorzugte Verfahrensvarianten bzw. Ausführungsformen sind den jeweils zugehörenden Unteransprüchen zu entnehmen.

Bei dem erfindungsgemäßen galvanischen Selektiv-Beschichtungsverfahren werden zunächst die später zu galvanisierenden Oberflächenbereiche in einem ersten Maskierungsschritt mit einer schmelzflüssigen, wachsartigen wasserlöslichen Substanz beschichtet oder maskiert. Diese wird so gewählt, dass sie innerhalb kurzer Zeit nach dem Aufbringen erstarrt, so dass ein unerwünschtes Verschmieren der aufgebrachten ersten Maskierungsschicht, oder eine eventuelles Unterwandern bei einer nachfolgenden Weiterverarbeitung der Metalloberfläche zuverlässig vermieden wird. Das Erstarren der schmelzflüssigen Substanz erfolgt hierbei wesentlich schneller als das Trocknen eines herkömmlichen Lacks, so dass sich die gewünschte Maskierungsschicht sehr viel schneller und präziser aufbringen lässt als eine Belackung bei einem herkömmlichen Belackungsverfahren.

In der Praxis haben sich insbesondere 1-Hexadecanol mit einer Schmelztemperatur von etwa 52 °C, 1-Octadecanol mit einer Schmelztemperatur von etwa 55 °C oder auch Mischungen aus diesen beiden Substanzen als wachsartige Maskierungssubstanz bewährt. Vorzugsweise kann jedoch auch Polyethylenglykol (PEG) mit einem mittleren Molekulargewicht zwischen etwa 1000 und 35000, insbesondere zwischen etwa 8000 und etwa 12000, verwendet werden. In der Praxis hat sich hierbei Polyethylenglykol mit einem mittleren Molekulargewicht von etwa 10000 am Besten bewährt. Polyethylenglykol ist je nach Molekulargewicht durch einen bestimmten Schmelzbereich charakterisiert. In der folgenden Tabelle 1 sind für mehrere beispielhafte mittlere Molekulargewichte aus dem angegebenen Molekulargewichtsbereich die jeweiligen Schmelzbereiche zusammenfassend dargestellt.

**Tabelle 1**

| Molekulargewicht | Schmelzbereich (°C) |
|---|---|
| 1000 | 37 - 40 |
| 1500 | 45 - 50 |
| 2000 | 50 - 52 |
| 3000 | 56 - 59 |
| 4000 | 59 - 61 |
| 6000 | 60 - 63 |
| 10000 | 63 - 65 |
| 12000 | 64 - 65 |
| 20000 | 63 - 66 |
| 35000 | 64 - 66 |

Die wachsartige Substanz kann aus dem schmelzflüssigen Zustand berührend oder berührungslos auf die selektiv galvanisch zu beschichtenden Bereiche der Metalloberfläche aufgetragen werden. Das Auftragen kann im einfachsten Fall durch einfaches Eintauchen der Metalloberfläche in einen mit der schmelzflüssigen Substanz gefüllten ersten Vorrats- oder Maskierungsbehälter erfolgen. Analog dem selektiven Löten kann das wachsartige Medium hierbei durch Anregung einer stehenden Welle sehr selektiv aufgebracht werden. Die schmelzflüssige Substanz kann jedoch beispielsweise auch durch Ausnutzung von Kapillarkräften auf die galvanisch zu beschichtenden Bereiche der Metalloberfläche aufgebracht werden. Diese Vorgehensweise ist insbesondere für das selektive Beschichten von Hohlteilen, Tulpen oder von Rund- und Vierkantstiften geeignet. Eine andere Möglichkeit besteht darin, die schmeizflüssigen Substanz durch selektives Aufpinseln oder Aufwalzen, d.h. eine Übertragung über eine rotierende Walze, auf die Metalloberfläche aufzubringen. Das Auftragen kann auch durch selektives Aufspritzen, Aufsprühen oder Aufdrucken mittels einer geeigneten Spritz-, Sprüh-, oder Druckeinrichtung (beispielsweise durch Siebdruck) oder eines geeigneten Drucker-Systems oder auf eine an sich bekannte andere Art und Weise erfolgen.

Beim Aufbringen der wachsartigen Substanz können die nicht zu beschichtenden oder zu maskierenden Oberflächenbereiche gegebenenfalls auch mittels einer auf die Oberfläche aufgepressten dünnen Maske aus einem geeigneten Kunststoff, wie beispielsweise Polyester oder Polyimid, oder einem geeigneten Metall abgedeckt werden.

Durch die beschriebene Vorgehensweise lassen sich gewünschte Maskierungsschichten nahezu beliebiger Gestalt mit einfachen Maskierungssystemen bei geringen Kosten sehr einfach, schnell und äußerst präzise aufbringen. Das Verfahren ermöglicht eine hohe Flexibilität und ist insbesondere auch für dreidimensionale Werkstücke mit unterschiedlichsten Geometrien, wie z.B. Hülsen, Tulpen sowie Rund- oder Vierkantstifte oder dreidimensional stark ausgebogene Teile, geeignet, die sich mit herkömmlichen Verfahren nur schwer maskieren lassen. So können beispielsweise auf einfache Art und Weise bei dreidimensional ausgebogenen Stanzteilen einseitige Bereiche für eine nachfolgende galvanische Beschichtung freigehalten werden, die einer selektiven direkten Belackung nicht zugänglich sind.

Durch das erfindungsgemäße Aufbringen der schmelzflüssigen Substanz lassen sich zudem auch schädliche Lackspritzer oder Lackbenetzungen im Kontaktbereich elektrischer oder elektronischer Bauteile zuverlässig verhindern, die bei allen herkömmlichen selektiven Lackauftragungsverfahren ein großes Problem darstellen.

Zur Gewährleistung optimaler Verarbeitungseigenschaften wird die wachsartige Substanz vorzugsweise mittels einer ersten elektrischen Heizeinrichtung auf eine bestimmte, substanzabhängige vorgebbare erste Soll-Verarbeitungstemperatur von beispielsweise etwa 40 -70 °C aufgeheizt und innerhalb bestimmter Temperaturtoleranzen auf dieser Soll-Verarbeitungstemperatur gehalten. Die Heizeinrichtung wird durch eine zugeordnete Steuerungseinrichtung bedarfsgerecht gesteuert, welche die Temperatursignale zumindest eines die Temperatur der wachsartigen Substanz kontinuierlich überwachenden Temperatursensors erfasst und auswertet Insbesondere bei Verwendung von Metallkapillaren kann das wachsartige Medium somit dauerhaft flüssig sehr selektiv auf die Oberfläche aufgetragen werden, während Lacke in Zuleitungen, die zur selektiven Belackung nötig sind, üblicherweise recht schnell eintrocknen. Auch ein in einem Vorratsbehälter erstarrtes wachsartiges Medium wird durch einfaches Aufheizen auf seine soll-Verarbeitungstemperatur sofort wieder betriebsbereit. Dies ist bei einem Lacksystem so nicht möglich.

Zur Gewährleistung einer ordnungsgemäßen Beschichtung wird die zu beschichtende Metalloberfläche vor dem Aufbringen der wachsartigen Substanz vorzugsweise zunächst gereinigt und getrocknet.

Nach dem Aufbringen und Erstarrenlassen der wachsartigen Maskierungssubstanz wird auf die zu beschichtenden oder zu lackierenden und nicht wachsartig maskierten Oberflächenbereiche als zweite Maskierungsschicht ein flüssiges und möglichst schnelltrocknendes Dielektrikum oder ein Lack aufgebracht, der innerhalb von Sekunden auf der Metalloberfläche trocknet. Das Dielektrikum oder der Lack wird hierbei so gewählt, dass er zumindest für die Zeit der nachfolgenden Weiterverarbeitung des Metalloberfläche, d.h. für das anschließende selektive galvanische Beschichten, abriebfest, haftfest und chemisch stabil ist. Er ist zumindest für mehrere Minuten in Säuren, Laugen und komplexbildnerhaltigen Elektrolyten und bei einem Stromfluß durch das Metall beständig. Diese Anforderungen werden beispielsweise durch eine MEK-haltige (Methyl-Ethyl-Ketonhaltige) pigmentfreie Tinte erfüllt.

Das flüssige Dielektrikum oder der Lack kann hierbei sowohl selektiv nur auf die zu beschichtenden und nicht wachsartig maskierten Oberflächenbereiche als auch - der Einfachheit halber - vollflächig auf die gesamte Oberfläche aufgebracht werden. Beim vollflächigen Aufbringen wird auch die wachsartige Maskierungssubstanz entsprechend beschichtet.

Das Aufbringen kann berührend oder berührungslos erfolgen. Im einfachsten Fall wird die zu beschichtende Metalloberfläche einfach ganz oder teilweise in einen mit dem flüssigen Dielektrikum oder dem Lack gefüllten Vorrats- oder Beschichtungsbehälter eingetaucht. Das flüssige Dielektrikum oder der Lack kann jedoch auch auf andere bekannte Art und Weise, wie beispielsweise durch Aufspritzen, Aufsprühen, Aufpinseln oder Aufwalzen, auf die Metalloberfläche aufgebracht werden.

Vorzugsweise wird hierbei auch die Temperatur der aufzubringenden Flüssigkeit mittels einer zweiten elektrischen Heizeinrichtung auf eine vorgebbare zweite Soll-Verarbeitungstemperatur eingestellt. Eventuelle Abweichungen von dieser zweiten Soll-Verarbeitungstemperatur werden ebenfalls mittels zumindest eines Temperatursensors bestimmt, dessen Temperatursignale von einer mit der zweiten Heizeinrichtung elektrisch verbundenen Steuereinrichtung erfasst und ausgewertet werden.

Nach dem Trocknenlassen des Dielektrikums wird die erste Maskierungsschicht, d.h. die wachsartige wasserlösliche Substanz, mit darauf gegebenenfalls befindlichem Dielektrikum oder Lack mit Wasser, insbesondere warmes Wasser, vollständig entfernt, so dass an den zuerst maskierten Stellen wieder die reine Metalloberfläche erscheint, die dann auf gewünschte Art und Weise weiterbehandelt werden kann. Dieses Absprengen und Ablösen der selektiv aufgebrachten wachsartigen, wasserlöslichen Schicht (der ersten Maskierung) ermöglicht nicht nur das oben beschriebene einfache Aufbringen einer vollflächigen Dielektrikumsbeschichtung (der zweiten Maskierung) sondern bewirkt auch die gewünschte hohe Selektivität.

Das Ablösen der wachsartigen Substanz wird vorzugsweise durch eine starke Wasserbewegung unterstützt. Das Wasser, insbesondere warmes Wasser, kann beispielsweise in Form eines Wasserstrahls, insbesondere ein Hochdruckwasserstrahl, eingesetzt werden. Das Ablösen kann auch durch eine Beaufschlagung mit Ultraschall begünstigt werden. Da die genannten wachsartigen Substanzen in hohem Maß wasserlöslich sind, lassen sie sich auf die beschriebene Art und Weise ohne den Einsatz von Lösungsmitteln sehr einfach, schnell und im wesentlichen rückstandsfrei von der Oberfläche ablösen. Zudem sind sie auch nur sehr viel preiswerter als Lacke und können viel einfacher und präziser selektiv aufgebracht werden als diese. Das erfindungsgemäße Selektiv-Beschichtungsverfahren erweist sich somit im Vergleich zu herkömmlichen Belackungsverfahren sowohl ökologisch als auch ökonomisch als äußerst vorteilhaft.

Nach dem Ablösen der wachsartigen Substanz wird die Oberfläche vorzugsweise zunächst noch einmal auf an sich bekante Art und Weise für die Folgeprozesse nachbehandelt.

Anschließend werden die nunmehr freien Bereiche der Metalloberfläche der gewünschten Nachbehandlung unterzogen, indem sie, beispielsweise durch ein einfaches Tauchgalvanik-Verfahren, selektiv mit Metall beschichtet werden.

Nach erfolgter Nachbehandlung, d.h. nach einer Selektiv-Galvanisierung, wird auch die zweite Maskierungsschicht, d.h. das aufgebrachte Dielektrikum oder der Lack schließlich wieder vollständig in einer wässrigen alkalischen Lösung oder in einem Mikrophasenreiniger im wesentlichen rückstandsfrei entfernt. Hierbei wird insbesondere eine Lösung verwendet, durch welche die Metalloberfläche und eine auf sie aufgebrachte galvanische Beschichtung chemisch nicht angegriffen werden. Das Ablösen oder Entfernen des aufgebrachten Dielektrikums oder Lacks wird vorzugsweise durch Einwirkenlassen von Ultraschall begünstigt. Das Ablösen kann jedoch beispielsweise auch durch Kavitation und Verwendung eines kavitationsfähigen Mediums begünstigt werden. Zur Qualitätsverbesserung werden hierbei vorzugsweise durch eine Absaugeinrichtung alle eventuell freiwerdenden Dielektrikurns-, Lack- oder Schmutzpartikel abgesaugt, um eine unerwünschte Verschmutzung der Metalloberfläche zu verhindern.

Die bearbeitete Metalloberfläche wird schließlich vorzugsweise abschließend noch ein weiteres Mal in einer geeigneten Reinigungs- und Trocknungseinrichtung gereinigt und getrocknet.

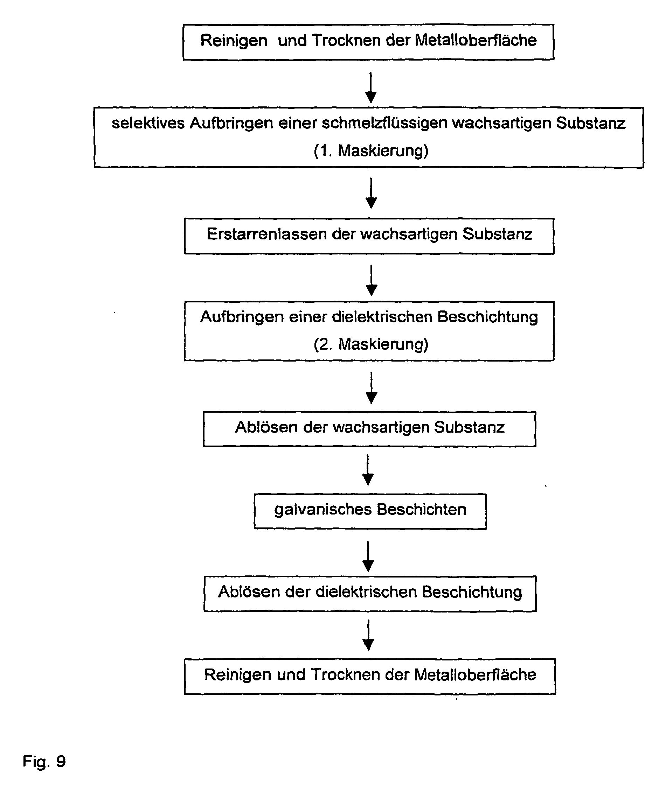

Die beschriebene erfindungsgemäße Prozessfolge ist in Fig. 9 anhand eines Flussdiagramms noch einmal schematisch dargestellt.

Ein Selektiv-Beschichtungssystem zur Durchführung dieses erfindungsgemäßen Verfahrens umfasst eine Halte-, Führungs- oder Transporteinrichtung für ein zu beschichtendes Metall, durch welche das Metall mit hoher Lagepräzision positioniert und geführt wird. Es umfasst zudem eine erste Maskierungs- oder Beschichtungseinrichtung zum selektiven Aufbringen einer schmelzflüssigen, wachsartigen wasserlöslichen Substanz auf die galvanisch zu beschichtenden Oberflächenbereiche des zu beschichtenden Metalls, eine zweite Maskierungs- oder Beschichtungseinrichtung zum anschließenden Aufbringen eines flüssigen Dielektrikums oder einer flüssigen Belackung auf die nicht galvanisch zu beschichtenden Oberflächenbereiche des zu beschichtenden Metalls, eine Wasser-Ablöseeinrichtung zum Ablösen der wachsartigen wasserlöslichen Substanz von der Metalloberfläche, eine der Wasserablöseeinrichtung nachgeschaltete galvanische Beschichtungseinrichtung und eine zugeordnete Steuerungseinrichtung zur Steuerung des erfindungsgemäßen Selektiv-Beschichtungsprozesses.

Die erste Maskierungs- oder Beschichtungseinrichtung umfasst insbesondere zumindest einen ersten Temperatursensor zur Bestimmung der Temperatur der aufzubringenden wachsartigen Substanz und eine erste elektrische Heizeinrichtung zum Aufheizen dieser Substanz auf eine vorgebbare erste Soll-Verarbeitungstemperatur. Der zumindest eine Temperatursensor und die elektrische Heizeinrichtung sind mit der genannten Steuerungseinrichtung elektrisch verbunden, welche die Temperatursignale des zumindest einen Temperatursensors erfaßt und die elektrische Heizeinrichtung in Abhängigkeit von den erfassten Temperatursignalen so ansteuert, dass die Substanztemperatur die erste Soll-Verarbeitungstemperatur erreicht und innerhalb bestimmter Toleranzgrenzen auch beibehält. Diese erste Soll-Verarbeitungstemperatur oder der erste Temperatur-Sollwert ist in Abhängigkeit von der jeweils verwendeten wachsartigen Substanz geeignet einstellbar, so dass sich diese beim Aufbringen im gewünschten schmelzflüssigen Zustand befindet.

Die erste Maskierungs- oder Beschichtungseinrichtung kann beispielsweise eine erste Spritz- oder Sprüheinrichtung für die wachsartige Substanz oder auch eine geeignete Kapillareinrichtung zum Aufbringen dieser Substanz auf die Metalloberfläche umfassen. Sie kann beispielsweise jedoch auch einfach einen ersten Vorrats- oder Maskierungsbehälter für die wachsartige Substanz umfassen, in den das zu beschichtende Metall eintauchbar ist oder eingetaucht wird. Des weiteren kann auch eine erste Walzen-, Bürsten- oder Pinseleinrichtung zum Aufwalzen, Aufbürsten oder Aufpinseln dieser Substanz auf die Metalloberfläche vorgesehen sein. Die erste Maskierungseinrichtung kann zudem auch eine Maskeneinrichtung, wie z.B. eine dünne Kunststoff- oder Metall-Maske, zum Abdecken oder Maskieren der nicht mit der wachsartigen Substanz zu beschichtenden Oberflächenbereiche umfassen. Eine solche Kunststoffmaske kann beispielsweise aus Polyester oder Polyimid bestehen.

Der ersten Maskierungs- oder Beschichtungseinrichtung ist vorzugsweise zumindest eine erste Reinigungs- und Trocknungseinrichtung zum Reinigen und Trocknen der Metalloberfläche vorgeschaltet.

Bei der zweiten Maskierungs- oder Beschichtungseinrichtung kann es sich um eine beliebige Einrichtung zum selektiven oder vollflächigen Aufbringen eine flüssigen Dielektrikums oder einer flüssigen Belackung auf die Metalloberfläche handeln. Sie kann beispielsweise eine zweite Spritz- oder Sprüheinrichtung, eine zweite Walzen- oder Bürsteneinrichtung und/oder einen zweiten Vorrats- oder Beschichtungsbehälter für das Dielektrikum oder den Lack umfassen, in den das zu beschichtende Metall eintauchbar ist oder eingetaucht wird.

Die zweite Maskierungs- oder Beschichtungseinrichtung umfasst insbesondere auch zumindest einen zweiten Temperatursensor zur Bestimmung der Temperatur des aufzubringenden Beschichtungsmaterials und eine zweite elektrische Heizeinrichtung zum Aufheizen des Beschichtungsmaterials auf eine vorgebbare zweite Soll-Verarbeitungstemperatur. Die Temperatursignale des zumindest einen Temperatursensors liegen an der Steuerungseinrichtung an, durch welche die zweite elektrische Heizeinrichtung in Abhängigkeit von den Temperatursignalen bedarfsgerecht gesteuert wird.

Zur Begünstigung des Ablöseprozesses für die wachsartige Substanz umfasst die Wasser-Ablöseeinrichtung vorzugsweise eine Wasserstrahleinrichtung, insbesondere eine Hochdruck-Wasserstrahleinrichtung. Bei anderen erfindungsgemäßen Ausgestaltungen kann sie auch eine erste Ultraschalleinrichtung oder eine erste Kavitationseinrichtung umfassen.

Der Wasser-Ablöseeinrichtung kann eine zweite Reinigungs- und Trocknungseinrichtung zum Reinigen und Trocknen der selektiv beschichteten Metalloberfläche nachgeschaltet sein.

Der Wasser-Ablöseeinrichtung ist eine Galvanisiereinrichtung, wie z.B. eine einfache Tauchgalvanikeinrichtung nachgeschaltet. Es kann ihr auch noch eine sonstige Einrichtung zur Weiterverarbeitung der selektiv beschichteten oder maskierten Metalloberfläche nachgeschaltet sein.

Zudem kann auch noch eine zweite Ablöseeinrichtung zum anschließenden rückstandsfreien Ablösen einer aufgebrachten dielektrischen Beschichtung oder Belackung (2. Maskierung) von der Metalloberfläche vorgesehen sein. Zur Begünstigung des Ablöseprozesses umfasst diese vorzugsweise eine zweite Ultraschalleinrichtung oder eine zweite Kavitationseinrichtung.

Der zweiten Ablöseeinrichtung kann schließlich noch eine dritte Reinigungs- und Trocknungseinrichtung zum Reinigen und Trocknen der Metalloberfläche nachgeschaltet sein. Die genannten Reinigungs- und Trocknungseinrichtungen sind vorzugsweise zur Erzeugung einer erhöhten Trocknungstemperatur von maximal etwa 200 °C ausgelegt, um durch möglicht kurze Trocknungszeiten hohe Beschichtungs- bzw. Bandgeschwindigkeiten erreichen zu können.

Weitere Einzelheiten, Merkmale und Vorteile der vorliegenden Erfindung ergeben sich nicht nur aus den zugehörigen Ansprüchen - für sich und/oder in Kombination - sondern auch aus der nachfolgenden Beschreibung bevorzugter erfindungsgemäßer Ausführungsbeispiele in Verbindung mit den zugehörigen Zeichnungen. In den Zeichnungen, in denen gleiche Teile mit gleichen Bezugszeichen versehen sind, zeigen in schematischer Darstellung:
- Fig. 1a - 1f: das selektive galvanische Beschichten einer im Querschnitt dargestellten dünnen Metall-Hülse unter Ausnutzung von Kapillarkräften;
- Fig. 2a - 2e: das selektive galvanische Beschichten eines gegurteten Vierkantstifts unter Ausnutzung von Kapillarkräften;
- Fig. 3a - 3e: das einseitige galvanische Beschichten eines 3-D-Teils;
- Fig. 4a und 4b: das selektive Aufbringen einer wachsartigen Maskierung mittels einer beheizten Kapillare;
- Fig. 5a - 5f: das selektive galvanische Beschichten eines Metallbandes;
- Fig. 6a und 6b: einen quer zur Laufrichtung bzw. in Laufrichtung dargestellten Tulpenkontakt;
- Fig. 6c - 6g: das selektive galvanische Beschichten eines Tulpenkontakts gemäß Fig. 6a;
- Fig. 7a - 7e: eine selektive galvanische Stiftbeschichtung; und
- Fig. 8a - 8e: das selektive galvanische Beschichten von Kontaktzonen in unterschiedlichen Ebenen.

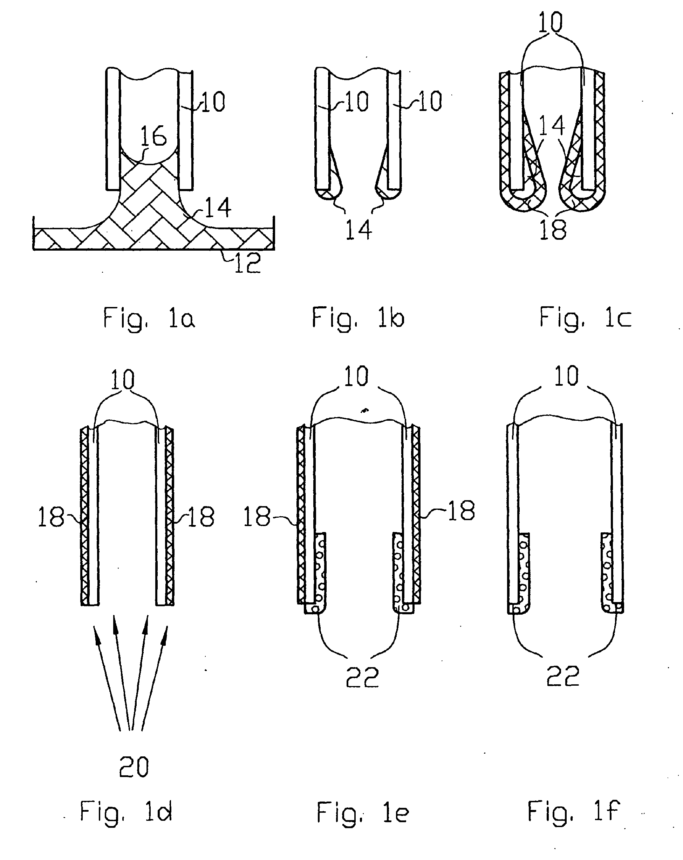

Die Fig. 1a - 1f veranschaulichen das erfindungsgemäße Selektiv-Beschichtungsverfahren anhand des selektiven Aufbringens einer galvanische Beschichtung auf der Innenseite einer dünnen Metall-Hülse 10.

Die zu beschichtende Metall-Hülse 10 wird zur Gewährleistung einer ordnungsgemäßen Beschichtung zunächst in einer (nicht dargestellten) ersten Reinigungs- und Trocknungseinrichtung gereinigt und bei höheren Temperaturen getrocknet.

Anschließend wird das galvanisch zu beschichtende untere Ende der Metall-Hülse 10 mittels einer (nicht dargestellten) Halte- und Führungseinrichtung in einem Vorrats- oder Maskierungsbehälter 12 in Kontakt mit schmelzflüssigem wachsartigem Polyethylenglykol (PEG) 14 mit einem mittleren Molekulargewicht von etwa 10⁴ gebracht. Wie oben bereits erwähnt wurde, kann gegebenenfalls jedoch auch - wie auch bei allen folgenden Ausführungsbeispielen - Polyethylenglykol mit einem anderen mittleren Molekulargewicht von etwa 1·10³ - 35·10³ und einem Schmelzbereich von etwa 37 - 66 °C verwendet werden. Der Vorratsbehälter 12 kann jedoch auch eine andere geeignete schmelzflüssige wachsartige Substanz mit vergleichbaren Materialeigenschaften, wie z.B. 1-Hexadecanol, 1-Octadecanol oder eine Mischung aus diesen beiden Substanzen enthalten.

Das Polyethylenglykol 14 wird durch eine (nicht dargestellte) elektrische Heizeinrichtung auf einer vorgegebenen Soll-Verarbeitungstemperatur von maximal etwa 120 °C gehalten. Die Einhaltung dieser Soll-Verarbeitungstemperatur wird mittels eines (nicht dargestellten) Temperatursensors in dem Vorratsbehälter 12 kontinuierlich überwacht, dessen Temperatursignale an einer (ebenfalls nicht dargestellten) zugeordneten Steuerungseinrichtung anliegen, durch welche die Temperatursignale ausgewertet und die Heizeinrichtung bedarfsgerecht gesteuert wird.

Das schmelzflüssige Polyethylenglykol 14 steigt gemäß Fig. 1a durch Kapillarkräfte in der engen Metall-Hülse 10 empor, benetzt dabei die Innenseite der Metall-Hülse 10 und bildet einen hohl eingewölbten Meniskus 16.

Die mit Polyethylenglykol 14 benetzte Metall-Hülse 10 wird dann gemäß Fig. 1b wieder aus dem Vorrats- oder Maskierungsbehälter 12 emporgezogen, wobei das auf der Innenseite der Metall-Hülse 10 aufgebrachte Polyethylenglykol 14 rasch erstarrt und eine wachsartige feste erste Maskierungsschicht 14 für das nachfolgende Aufbringen eines Dielektrikums bildet.

Das vorstehend beschriebene, erfindungsgemäße Maskieren von Werkstücken durch Eintauchen in eine schmelzflüssige wachsartige Substanz 14 und Ausnutzung von Kapillarkräften ist insbesondere für Hohlteile, Tulpen sowie für Rund- und Vierkantstifte geeignet.

Nach dem Erstarren des Polyethylenglykols 14 wird das untere Ende der Metall-Hülse 10 durch kurzes Eintauchen in einen (nicht dargestellten) Vorratsbehälter mit einer MEKhaltigen (Methy-Ethyl-Keton-haltigen) pigmentfreien Tinte 18 vollflächig mit einer entsprechenden dielektrischen Beschichtung 18 versehen. Die entsprechend beschichtete Metall-Hülse 10 ist in Fig. 1c dargestellt.

Die verwendete MEK-haltige Tinte ist schnell genug trocknend, hinreichend abrieb- und haftfest und auch in Säuren, Laugen, komplexbildnerhaltigen Elektrolyten sowie bei einem Stromfluß durch das Metall 10 zumindest für die Dauer des nachfolgenden Galvanisiervorgangs, d.h. zumindest für mehrere Minuten, ausreichend beständig. Es kann jedoch auch ein anderes geeignetes Dielektrikum 18 mit den entsprechenden Eigenschaften verwendet werden. Wie oben bereits erwähnt wurde, kann die dielektrische Beschichtung 18 beispielsweise auch mittels einer geeigneten Spritz- oder Sprüheinrichtung aufgebracht werden.

Zur Beschleunigung des Trocknungsprozesses kann die dielektrisch beschichtete Metall-Hülse 10 gegebenenfalls auch in einer (nicht dargestellten) zweiten Trocknungseinrichtung bei höheren Temperaturen getrocknet werden.

Nach dem Aufbringen der dielektrischen Beschichtung 18 wird das erstarrte wachsartige Polyethylenglykol 14 zusammen mit der darauf aufgebrachten dielektrischen Beschichtung 18 gemäß Fig. 1d mittels eines Hochdruck-Warmwasserstrahls 20 rückstandsfrei entfernt. Die Polyethylenglykolschicht 14 kann jedoch gegebenenfalls auch durch Eintauchen der Metall-Hülse 10 in Wasser und Beaufschlagung mit Ultraschall oder Kavitation entfernt werden.

Anschließend werden die ursprünglich mit Polyethylenglykol maskierten und nunmehr wieder freien Oberflächenbereiche in einer (nicht dargestellten) herkömmlichen Tauchgalvanikeinrichtung mit einem gewünschten Metall, wie beispielsweise Gold, Silber oder Zinn, galvanisch beschichtet oder plattiert. Fig. 1e zeigt das untere Ende der Metall-Hülse 10 mit der aufgebrachten galvanischen Beschichtung 22.

Nach dem Aufbringen der galvanischen Beschichtung 22 wird die Dielektrikumsschicht 18 durch Eintauchen der Metall-Hülse 10 in eine geeignete wässrige Lösung mit mikrodispersen Zuschlagsstoffen schließlich wieder im wesentlichen rückstandsfrei von der Oberfläche entfernt, so dass man als Ergebnis eine Metall-Hülse 10 erhält, deren unteres Ende gemäß Fig. 1f wunschgemäß auf der Innenseite selektiv galvanisch beschichtet ist.

Die wässrige Lösung wird hierbei so gewählt, daß die Metalloberfläche und die galvanische Beschichtung nicht angegriffen werden. Das Ablösen erfolgt unter Einwirkung von Ultraschall aus einer (nicht dargestellten) zugeordneten Ultraschalleinrichtung oder durch Kavitation in einer kavitationsfähigen Lösung, wie z.B. Kalilauge, da dies eine deutliche Beschleunigung des Ablösevorgangs bewirkt.

Die galvanisch beschichtete Metall-Hülse 10 wird schließlich abschließend noch in einer dritten Reinigungs- und Trocknungseinrichtung mit warmem Wasser gereinigt und bei höheren Temperaturen getrocknet.

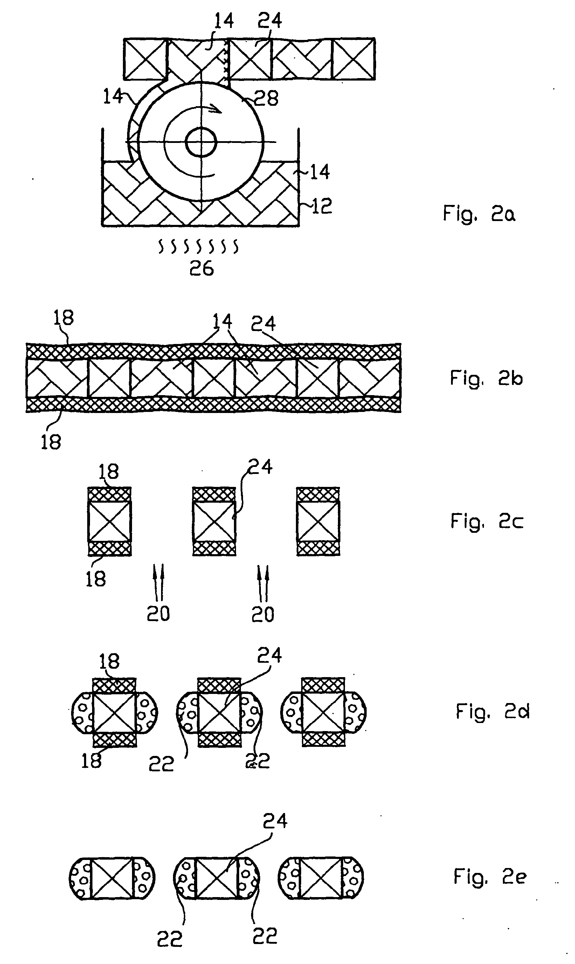

Das in den Fig. 2a - 2e dargestellte zweite erfindungsgemäße Ausführungsbeispiel veranschaulicht das selektive galvanische Beschichten eines Vierkantstifts 24 mittels einer Walzeneinrichtung 12, 26, 28 unter Ausnutzung von Kapillarkräften.

Die Walzeneinrichtung umfasst gemäß Fig. 2a wieder einen mit schmelzflüssigem Polyethylenglykol 14 gefüllten Vorrats- oder Maskierungsbehälter 12 mit einer Heizeinrichtung 26, durch die das Polyethylenglykol 14 auf seiner Soll-Verarbeitungstemperatur von etwa 63 - 65 °C gehalten wird. Die Heizeinrichtung 26 wird durch eine (nicht dargestellte) zugeordnete Steuerungseinrichtung bedarfsgerecht gesteuert, an dem die Temperatursignale eines (ebenfalls nicht dargestellten) Temperatursensors an dem Vorratsbehälter 12 anliegen, der zur kontinuierlichen Überwachung der Polyethylenglykol-Temperatur dient.

In dem Vorrats- oder Maskierungsbehälter 12 dreht sich eine Walze 28 im Uhrzeigersinn. Der untere Walzenbereich befindet sich in dem schmelzflüssigen Polyethylenglykol 14, so dass die Walzenoberfläche mit Polyethylenglykol 14 benetzt wird. Der aus dem Polyethylenglykol 14 auftauchende linke Bereich der Walzenoberfläche führt somit eine anhaftende dünne Polyethylenglykolschicht 14 in Drehrichtung der Walze 28 mit sich nach oben.

Der zu beschichtende Vierkantstift 24 wird so in Kontakt mit der Walzenoberfläche gebracht, dass das anhaftende Polyethylenglykol 14 durch Kapillarkräfte in die zu beschichtenden eng gegurteten Vierkant-Zwischenräume eindringt und diese im wesentlichen ausfüllt.

Nach dem selektiven Aufbringen der Polyethylenglykolschicht 14 auf den Vierkantstift 24 und dem anschließenden Erstarrenlassen dieser Schicht 14 wird der Vierkantstift 24 durch kurzes Eintauchen in einen (nicht dargestellten) Vorrats-, Beschichtungs- oder Maskierungsbehälter mit einem geeigneten flüssigen Dielektrikum 18 gemäß Fig. 2b vollflächig mit dem Dielektrikum 18 beschichtet. Wie bereits erwähnt wurde, kann das Dielektrikum 18 jedoch beispielsweise auch durch Aufspritzen, Aufsprühen oder Aufpinseln vollflächig auf die Oberflächen aufgebracht werden.

Nach dem Aufbringen und Trocknenlassen des Dielektrikums 18 wird die erstarrte Polyethylenglykol-Maskierungsschicht 14 gemäß Fig. 2c mittels eines Hochdruck-Warmwasserstrahls 20 wieder rückstandsfrei von der Metalloberfläche entfernt.

Anschließend werden die ursprünglich mit Polyethylenglykol 14 maskierten und nunmehr wieder freien Oberflächenbereiche des Vierkantstifts 24 in einer (nicht dargestellten) herkömmlichen Tauchgalvanikeinrichtung galvanisch mit einer geeigneten Metallschicht 22, wie beispielsweise eine Gold-, Silber- oder Zinn-Schicht, beschichtet oder plattiert. Der entsprechend beschichtete Vierkantstift 24 ist in Fig. 2d dargestellt.

Nach dem Aufbringen der galvanischen Beschichtung 22 wird die Dielektrikumsschicht 18 schließlich wiederum durch Eintauchen des Vierkantstifts 24 in eine geeignete wässrige alkalische Lösung mit/ohne mikrodisperse Zuschlagsstoffe im wesentlichen rückstandsfrei von der Oberfläche abgelöst, so dass gemäß Fig. 2e als Endergebnis der selektiv galvanisch beschichtete Vierkantstift 24 verbleibt. Das Ablösen erfolgt hierbei unter Einwirkung von Ultraschall aus einer (nicht dargestellten) zugeordneten Ultraschalleinrichtung, da sich hiermit eine deutliche Beschleunigung des Ablösevorgangs erreichen lässt. Die Dielektrikumsschicht 18 kann zum besseren Ablösen jedoch auch mittels einer Kavitationseinrichtung, d.h. eine kavitationserzeugende Einrichtung mit einem kavitationsfähigen Medium, wie z.B. Kalilauge, mit Kavitation beaufschlagt werden.

Zur Verbesserung der Beschichtungsqualität kann die Metalloberfläche hierbei auch wiederum den bereits beschriebenen Reinigungs- und Trocknungsschritten unterworfen werden.

Das in den Fig. 3a - 3e dargestellte dritte erfindungsgemäße Ausführungsbeispiel veranschaulicht das einseitige galvanische Beschichten eines (im Querschnitt dargestellten) nach unten ausgebogenen Stanzteils 30 mittels der Walzeneinrichtung 12, 26, 28 gemäß Fig. 2. Entsprechend dem vorigen Ausführungsbeispiel ist wiederum eine sich im Uhrzeigersinn drehende Walze 28 in einem beheizten und etwa bis zu ihrer Drehachse mit schmelzflüssigem Polyethylenglykol 14 gefüllten Vorrats-, Beschichtungs- oder Maskierungsbehälter 12 angeordnet, so dass der aus dem schmelzflüssigen Polyethylenglykol 14 auftauchende linke Bereich der Walzenoberfläche eine anhaftende dünne Polyethylenglykolschicht 14 in Drehrichtung der Walze 28 mit sich nach oben führt, die schließlich gemäß Fig. 3a den gesamten linken oberen Walzenquadranten bedeckt.

Das zu beschichtende und zuvor gereinigte und getrocknete Stanzteil 30 wird in Richtung des Pfeils 32 von rechts nach links über die Walze 28 geführt, wobei der einseitig zu beschichtende vorspringende Bereich 30a des Stanzteils 30 nach unten weißt. Dessen Abstand zu der Walze 28 wird hierbei so gewählt, dass er mit seinem unteren Ende die Polyethylenglykolschicht 14 von der Walzenoberfläche abstreift. Das abgestreifte Polyethylenglykol 14 sammelt sich auf der zu maskierenden linken Seite des vorspringenden Bereichs 30a an und bedeckt diesen gemäß Fig. 3a schließlich vollständig.

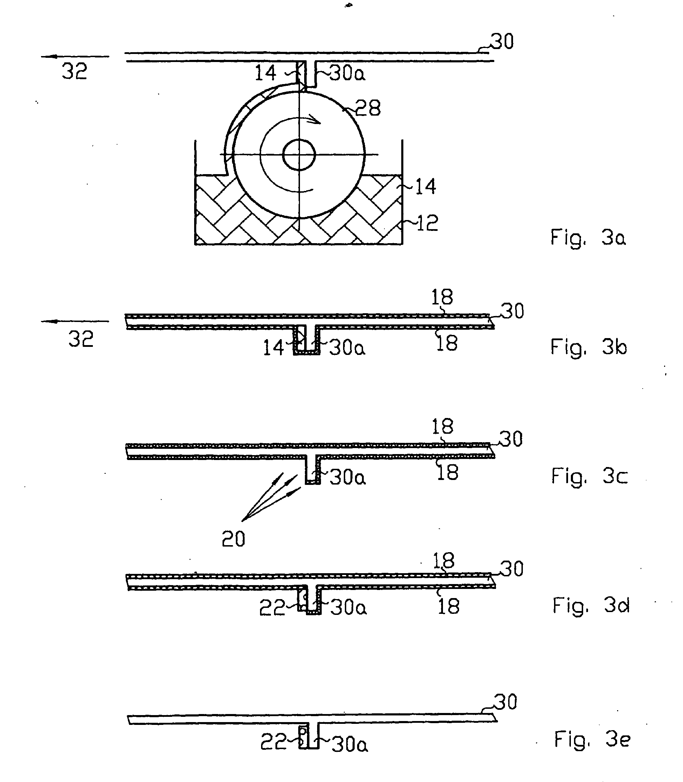

Nach dem selektiven Aufbringen der Polyethylenglykolschicht 14 auf das Stanzteil 30 und dem anschließenden Erstarrenlassen wird das Stanzteil 30 durch kurzes Eintauchen in einen (nicht dargestellten) Vorrats-, Beschichtungs- oder Maskierungsbehälter mit einem geeigneten flüssigen Dielektrikum 18 gemäß Fig. 3b vollflächig mit dem Dielektrikum 18 beschichtet. Wie bereits erwähnt, kann das Dielektrikum 18 jedoch beispielsweise auch durch Aufspritzen, Aufsprühen oder Aufpinseln auf die Oberflächen aufgebracht werden.

Nach dem Aufbringen des Dielektrikums 18 wird die erstarrte Polyethylenglykol-Maskierungsschicht 14 gemäß Fig. 3c mittels eines Hochdruck-Warmwasserstrahls 20 wieder rückstandsfrei von der Metalloberfläche entfernt.

Anschließend werden die ursprünglich mit Polyethylenglykol 14 maskierten und nunmehr wieder freien Oberflächenbereiche des Stanzteils 30 in einer (nicht dargestellten) herkömmlichen Tauchgalvanikeinrichtung galvanisch mit einer geeigneten Metallschicht 22, wie beispielsweise eine Gold-, oder Silber-Plattierung, beschichtet. Das entsprechend beschichtete Stanzteil 30 ist in Fig. 3d dargestellt.

Nach dem Aufbringen der galvanischen Beschichtung 22 wird die Dielektrikumsschicht 18 schließlich wiederum durch Eintauchen des Stanzteils 30 in eine geeignete wässrige alkalische Lösung mit mikrodispersen Zuschlagsstoffen im wesentlichen rückstandsfrei von der Oberfläche abgelöst. so dass gemäß Fig. 3e als Endergebnis das selektiv galvanisch beschichtete Stanzteil 30 verbleibt. Das Ablösen erfolgt hierbei unter Einwirkung von Ultraschall aus einer (nicht dargestellten) zugeordneten Ultraschalleinrichtung, da sich hiermit eine deutliche Beschleunigung des Ablösevorgangs erreichen lässt. Die Dielektrikumsschicht 18 kann zum besseren Ablösen jedoch auch wieder mittels einer Kavitationseinrichtung mit Kavitation beaufschlagt werden.

Zur Verbesserung der Beschichtungsqualität kann die Metalloberfläche hierbei auch wiederum den bereits beschriebenen Reinigungs- und Trocknungsschritten unterworfen werden.

Durch die beschriebene erfindungsgemäße Vorgehensweise können insbesondere bei dreidimensionalen Werkstücken auf einfache Art und Weise einseitig Oberflächenbereiche für eine nachfolgende selektive galvanische Beschichtung freigehalten werden, die einer herkömmlichen, selektiven direkten Belackung nicht zugänglich sind.

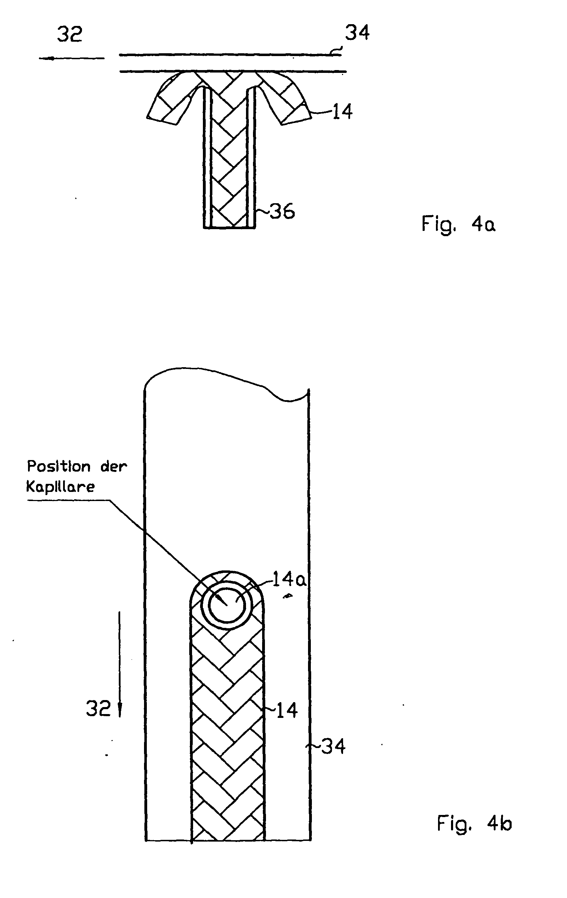

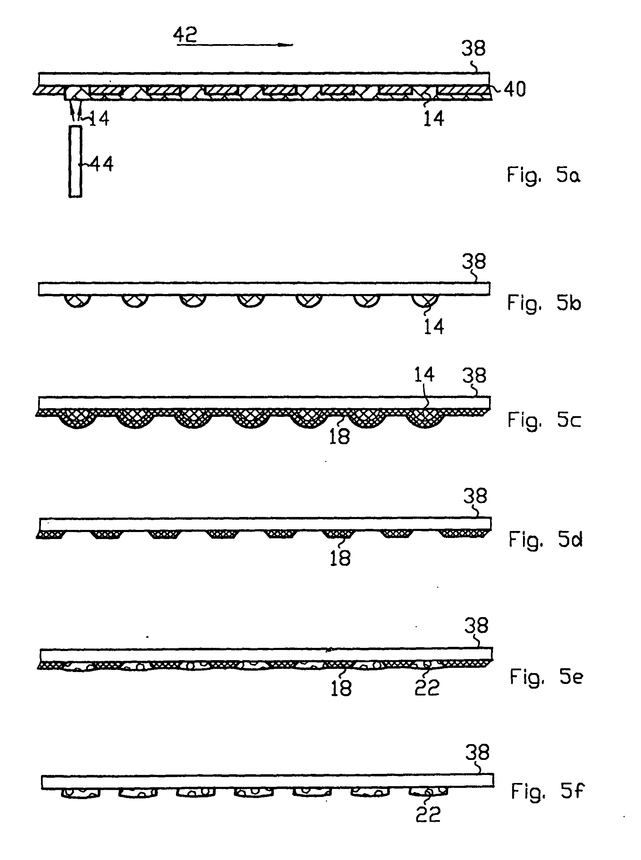

Bei dem in den Fig. 4 dargestellten vierten erfindungsgemäßen Ausführungsbeispiel wird die Unterseite eines Metallbandes 34 selektiv mit Polyethylenglykol 14 beschichtet. Das zu beschichtende Metallband 34 wird hierbei gemäß der schematischen Seitenansicht in Fig. 4a in Richtung des Pfeils 32 von rechts nach links mit konstanter Geschwindigkeit über einer beheizten Kapillareinrichtung 36 entlangbewegt, durch die das schmelzflüssige Polyethylenglykol 14 mit hoher Präzision streifenförmig auf die Metalloberfläche aufgebracht wird. Der entsprechende Polyethylenglykolstreifen 14 in der Mitte des Metallbandes 34 ist in der Draufsicht gemäß Fig. 4b noch einmal schematisch dargestellt. Der Beginn 14a des Polyethylenglykolstreifen 14 entspricht der Position der beheizten Kapillareinrichtung 36.

Das selektiv beschichtete oder maskierte Metallband 34 kann nun auf die oben beschriebene erfindungsgemäße Art und Weise weiterbearbeitet werden. Die nicht maskierten beiden Randbereiche des Metallbandes 34 werden hierbei zunächst wiederum mit einem geeigneten Dielektrikum 18 beschichtet oder maskiert indem das Metallband 34 beispielsweise einfach mit eine bestimmten Geschwindigkeit durch einen mit dem Dielektrikum gefüllten Vorratsbehälter geleitet wird. Anschließend wird die wachsartige Polyethylenglykol-Maskierungsschicht 14 mit warmem Wasser 20 im wesentlichen rückstandsfrei abgelöst. Das Ablösen kann hierbei am einfachsten in einem Warmwasserbad unter Einwirkung von Ultraschall erfolgen. Nach dem Ablösen der Polyethylenglykolschicht 14 wird der ursprünglich maskierte und nunmehr wieder freie Oberflächenstreifen mit einem geeigneten Metall 22 selektiv galvanisch beschichtet oder plattiert. In einem letzten Verfahrensschritt wird schließlich die aufgebrachte Dielektrikumsschicht 18 in einer wässrigen alkalischen Lösung rückstandsfrei entfernt. Zur Verbesserung der Beschichtungsqualität kann die Metalloberfläche hierbei auch wiederum den bereits beschriebenen Reinigungs- und Trocknungsschritten unterworfen werden.

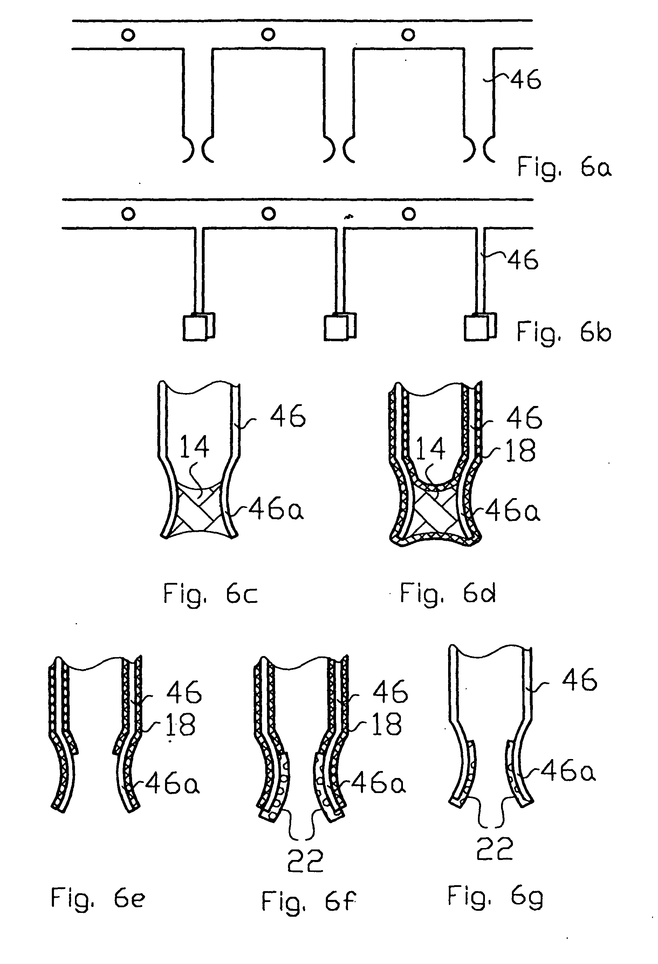

Die Fig. 5a - 5f veranschaulichen in einem fünften erfindungsgemäßen Ausführungsbeispiel noch das Maskieren und das anschließende selektive galvanische Beschichten eines Endlos-Metallbandes 38 mit Gold, Silber, Zinn oder dergleichen. Wie üblich, wird die zu beschichtende Oberfläche des Metallbandes 38 hierbei zunächst gereinigt und getrocknet. Anschließend werden die nicht galvanisch zu beschichtenden Oberflächenbereiche mit einer dünnen Polyimid-Maske 40 abgedeckt oder maskiert. Wie oben bereits erwähnt wurde, kann hierfür jedoch beispielsweise auch eine dünne Maske aus einem anderen geeigneten Kunststoff, wie z.B. Polyester, oder eine dünne Metallmaske verwendet werden.

Das Metallband 38 wird nun mit der maskierten Seite nach unten mittels (einer nicht dargestellten) Führungs- oder Transporteinrichtung mit konstanter Geschwindigkeit in Richtung des Pfeils 42 von links nach rechts über einem elektrisch beheizten Spritz- oder Sprühkopf 44 vorbeibewegt. Durch diesen wird die maskierte Unterseite des Metallbandes 38 gemäß Fig. 5a vollflächig mit schmelzflüssigem Polyethylenglykol 14 beschichtet, das unmittelbar nach dem Aufbringen wachsartig erstarrt.

Nach dem Passieren des Spritz- oder Sprühkopfs 44 wird die Maske 40 von der Oberfläche abgenommen, so dass gemäß Fig. 5b nur noch die nicht maskierten und später zu galvanisierenden Oberflächenbereiche mit einer erstarrten wachsartigen Polyethylenglykolschicht 14 versehen sind.

Anschließend wird die Unterseite des Metallbandes 38 gemäß Fig. 5c vollflächig mit einer dielektrischen Beschichtung oder Belackung 18 versehen. Diese kann beispielsweise durch einfaches Aufspritzen oder Aufsprühen eines geeigneten schnelltrocknenden Dielektrikums mittels einer (nicht dargestellten) geeigneten Spritz- oder Sprüheinrichtung aufgebracht werden.

Nach dem Trocknenlassen der dielektrischen Beschichtung 18 wird die erstarrte Polyethylenglykol-Maskierung 14 zusammen mit dem auf ihr aufgebrachten Dielektrikum 18 mittels eines Hochdruckwasserstrahls 20 rückstandsfrei abgelöst, so dass gemäß Fig. 5d nur noch die ursprünglich mit der Maske 40 maskierten Oberflächenbereiche selektiv dielektrisch beschichtet 18 sind. Gegebenenfalls könnte das Metallband 38 zum Ablösen der Polyethylenglykol-Maskierung 14 beispielsweise auch durch ein Wasserbad geleitet und dabei mit Ultraschall oder Kavitation beaufschlagt werden.

Die ursprünglich mit Polyethylenglykol 14 beschichteten und nunmehr freien Oberflächenbereiche des Metallbandes 38 werden nun gemäß Fig. 5e auf herkömmliche Art und Weise, z.B. in einer Tauchgalvanikeinrichtung, mit einer geeigneten galvanischen Beschichtung 22 versehen.

Anschließend wird die selektive dielektrische Beschichtung 18 auf die oben beschriebene Art und Weise mit Ultraschall oder Kavitation beaufschlagt und mittels eines Mikrophasenreinigers im wesentlichen rückstandsfrei von der Metalloberfläche abgelöst; so dass gemäß Fig. 5f das Metallband 38 mit aufgebrachter selektiver galvanischer Beschichtung 22 verbleibt. Dieses kann dann, wie üblich, in einem letzten Verfahrensschritt noch gereinigt und getrocknet werden.

Die Fig. 6c - 6g veranschaulichen in einem weiteren erfindungsgemäßen Ausführungsbeispiel das Industriell äußerst wichtige, selektive galvanische Beschichten einer Kontakttulpe oder eines Tulpenkontakts 46 quer zur Laufrichtung. Die Fig. 6a und 6b zeigen solche Tulpenkontakte 46 quer zur Laufrichtung bzw. in Laufrichtung..

Der Tulpenkontakt 46 wird zunächst wiederum gereinigt und getrocknet bevor die galvanisch zu beschichtenden Kontaktfinger 46a in Kontakt mit schmelzflüssigem wachsartigem Polyethylenglykol 14 gebracht werden, das in einem (nicht dargestellten) Vorrats- oder Maskierungsbehälter auf einer bestimmten Soll-Verarbeitungstemperatur gehalten wird. Das schmelzflüssige Polyethylenglykol 14 steigt gemäß Fig. 1a durch Kapillarkräfte zwischen den Kontaktfingern 46a nach oben und füllt den Zwischenraum zwischen den Kontaktfingern 46a aus.

Nach dem Erstarrentassen des Polyethylenglykols 14 wird der mit Polyethylenglykol 14 maskierte Tulpenkontakt 46 durch Eintauchen in ein (nicht dargestelltes) geeignetes Beschichtungsbad vollständig mit einer entsprechenden dielektrischen Lackierung 18 versehen. Der entsprechend lackierte oder maskierte Tulpenkontakt 46 ist in Fig. 6d dargestellt.

Im nächsten Verfahrensschritt wird die aufgebrachte Polyethylenglykol-Maskierung 14 gemäß Fig. 6e mittels eines Hochdruck-Wasserstrahls 20 wieder vollständig von der Metalloberfläche abgelöst, um den galvanisch zu beschichtenden Bereich des Metallstifts 14 wieder freizulegen. Das Ablösen der Polyethylenglykol-Maskierung 14 kann jedoch beispielsweise auch durch Eintauchen in ein Wasserbad und Beaufschlagung mit Ultraschall erfolgen.

Der freie Oberflächenbereich des Tulpenkontakts 46 wird nun gemäß Fig. 6f in einer (nicht dargestellten) Tauchgalvanikeinrichtung mit der gewünschten galvanischen Beschichtung 22 versehen.

Anschließend wird die selektive dielektrische Beschichtung 18 auf die oben beschriebene Art und Weise mit Ultraschall oder Kavitation beaufschlagt und mittels eines Mikrophasenreinigers im wesentlichen rückstandsfrei von der Metalloberfläche abgelöst, so dass gemäß Fig. 6g der Tulpenkontakt 46 mit aufgebrachter selektiver galvanischer Beschichtung 22 verbleibt. Eine qualitativ vergleichbare selektive Beschichtung eines Tulpenkontaktes gestattet kein anderes herkömmliches Selektiv-Beschichtungsverfahren. Dies gilt insbesondere quer zur Laufrichtung.

Der galvanisch beschichtete Tulpenkontakt 46 kann dann, wie üblich, in einem letzten Verfahrensschritt noch gereinigt und getrocknet werden.

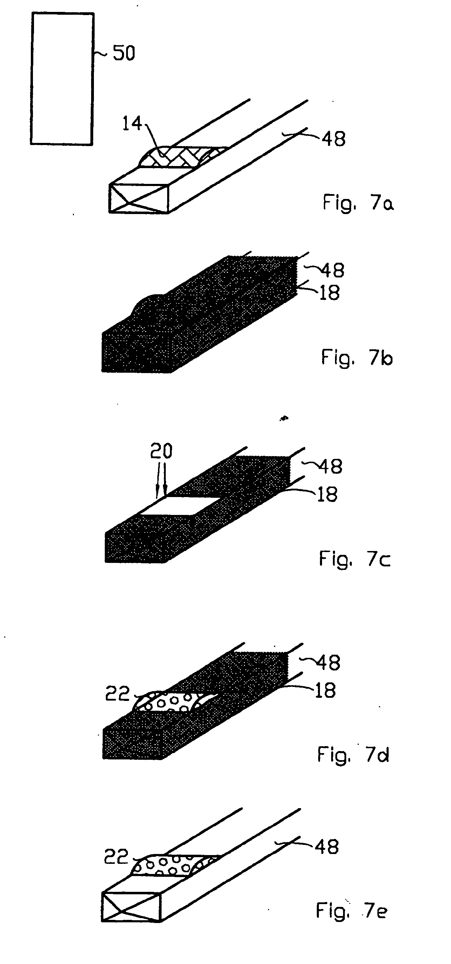

Die Fig. 7a - 7e veranschaulichen in einem weiteren erfindungsgemäßen Ausführungsbeispiel das selektive galvanische Beschichten eines Metallstifts 48.

Der Metallstift 48. wird zunächst wiederum gereinigt und getrocknet bevor die galvanisch zu beschichtende Stelle mit einer Polyethylenglykol-Maskierung 14 versehen wird. Die Polyethylenglykol-Maskierung 14 wird gemäß Fig. 7a mittels eines Filzes 50 auf die Metalloberfläche aufgebracht. Der Metallstift 48 kann jedoch beispielsweise auch mittels einer geeigneten Rollen- oder Walzeneinrichtung entsprechend maskiert werden.

Anschließend wird der maskierte Metallstift 48 durch Eintauchen in ein (nicht dargestelltes) geeignetes Beschichtsungsbad vollständig mit einer entsprechenden dielektrischen Lackierung oder Maskierung versehen. Der entsprechend lackierte Metallstift 48 ist in Fig. 7b dargestellt.

Im nächsten Verfahrensschritt wird die aufgebrachte Polyethylenglykol-Maskierung 14 gemäß Fig. 7c mittels eines Hochdruck-Wasserstrahls 20 wieder vollständig von der Metalloberfläche abgelöst, um den galvanisch zu beschichtende Bereich des Metallstifts 14 wieder freizulegen. Das Ablösen der Polyethylenglykol-Maskierung 14 kann jedoch beispielsweise auch durch Eintauchen in ein Wasserbad und Beaufschlagung mit Ultraschall erfolgen.

Der freie Oberflächenbereich des Metallstifts 48 wird nun gemäß Fig. 7d in einer (nicht dargestellten) Tauchgalvanikeinrichtung mit der gewünschten galvanischen Beschichtung 22 versehen.

Anschließend wird die selektive dielektrische Beschichtung 18 auf die oben beschriebene Art und Weise mit Ultraschall oder Kavitation beaufschlagt und mittels eines Mikrophasenreinigers im wesentlichen rückstandsfrei von der Metalloberfläche abgelöst, so dass gemäß Fig. 7e der Metallstift 48 mit aufgebrachter selektiver galvanischer Beschichtung 22 verbleibt. Der galvanisch beschichtete Metallstift 48 kann dann, wie üblich, in einem letzten Verfahrensschritt noch gereinigt und getrocknet werden.

So selektiv wie in dem vorliegenden Ausführungsbeispiel und ohne Auslaufzone kann der Metallstift 48 mittels keines anderen, kostenmäßig vergleichbaren herkömmlichen Selektiv-Beschichtungsverfahrens beschichtet werden.

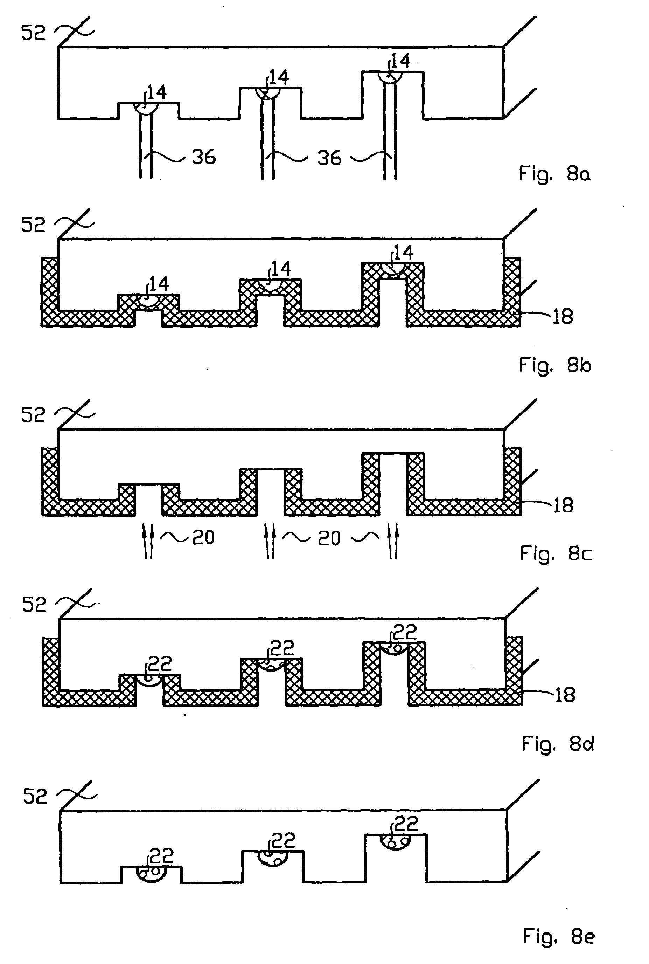

Die Fig. 8a - 8e veranschaulichen schließlich in einem letzten erfindungsgemäßen Ausführungsbeispiel noch die Herstellung von Kontaktzonen in drei unterschiedlichen Ebenen eines zuvor gereinigten und getrockneten Werkstücks oder Bauteils 52.

Die galvanisch zu beschichtenden unterschiedlichen Ebenen des Bauteils 52 werden zunächst wiederum jeweils mit einer Polyethylenglykol-Maskierung 14 versehen. Die Maskierungen 14 werden gemäß Fig. 8a durch drei beheizte Kapillareinrichtungen 36 mit hoher Präzision auf die Oberfläche aufgebracht. Die Längen der Kapillareinrichtungen 36 sind hierbei jeweils an die unterschiedliche Höhe der zu beschichtenden Ebene angepasst.

Mit einstellbaren Düsen und eine entsprechende Steuerung der Übertragung lassen sich sehr selektiv beliebige Muster, wie beispielsweise Punkte oder Streifen, herstellen. Die zu maskierenden Oberflächenbereiche können jedoch bei Bedarf auch komplett mit einer wachsartigen Beschichtung versehen werden.

Anschließend werden die Unterseite und die Seitenflächen des maskierten Bauteis 52 durch Eintauchen in ein (nicht dargestelltes) geeignetes Beschichtungsbad vollständig mit einer entsprechenden dielektrischen Lackierung 18 versehen. Das entsprechend lackierte Bauteil 52 ist in Fig. 8b dargestellt.

Im nächsten Verfahrensschritt werden die aufgebrachten Polyethylenglykol-Maskierungen 14 gemäß Fig. 8c durch Hochdruck-Wasserstrahle 20 wieder vollständig von der Metalloberfläche abgelöst, um die galvanisch zu beschichtende Bereiche des Bauteils 52 für eine nachfolgende Galvanisierung wieder freizulegen. Das Ablösen der Polyethylenglykol-Maskierung 14 kann auch hier beispielsweise wiederum durch Eintauchen in ein Wasserbad und Beaufschlagung mit Ultraschall erfolgen.

Die freien Oberflächenbereiche des Bauteils 52 werden nun gemäß Fig. 8d in einer (nicht dargestellten) Tauchgalvanikeinrichtung mit der gewünschten galvanischen Beschichtung 22 versehen.

Anschließend wird die selektive dielektrische Beschichtung 18 wiederum mit Ultraschall oder Kavitation beaufschlagt und mittels eines Mikrophasenreinigers im wesentlichen rückstandsfrei von der Metalloberfläche abgelöst, so dass gemäß Fig. 8e das Bauteil 52 mit aufgebrachter selektiver galvanischer Beschichtung 22 verbleibt. Das galvanisch beschichtete Bauteil 52 kann dann, wie üblich, in einem letzten Verfahrensschritt noch gereinigt und getrocknet werden.

## Patentansprüche

1. Verfahren zum selektiven galvanischen Beschichten von Metalloberflächen mit folgenden Verfahrensschritten:
- erstes selektives Maskieren der galvanisch zu beschichtenden Oberflächenbereiche mit einer schmelzflüssigen wachsartigen Substanz (14);
- zweites Maskieren der nicht galvanisch zu beschichtenden Oberflächenbereiche mit einem flüssigen Dielektrikum (18);
- Ablösen der wachsartigen Substanz (14) mit Wasser (20); und
- selektives galvanisches Beschichten der freien Oberflächenbereiche.

2. Verfahren nach Anspruch 1,
**dadurch gekennzeichnet,**
**daß** als wachsartige Substanz (14) Polyethylenglykol, 1-Hexadecanol, 1-Octadecanol, eine Mischung aus 1-Hexadecanol und 1-Octadecanol oder eine ähnliche durch Wasser ablösbare Substanz verwendet wird.

3. Verfahren nach Anspruch 2,
**dadurch gekennzeichnet,**
**daß** Polyethylenglykol mit einem mittleren Molekulargewicht von 8000 - 12000 verwendet wird.

4. Verfahren nach einem der vorhergehenden Ansprüche,
**dadurch gekennzeichnet,**
**dass** die schmelzflüssige wachsartige Substanz (14) durch:
- Ausnutzung von Kapillarkräften nach einem Inkontaktbringen der Metalloberfläche mit dieser Substanz (14) oder einem Eintauchen in diese Substanz (14) ;
- Aufspritzen, Aufsprühen oder Aufpinseln;
- Eintauchen der Metalloberfläche in diese Substanz (14);
- Übertragung auf die Metalloberfläche über zumindest eine rotierende Walze oder Rolle (28);
- einen Filz (50); und/oder eine
- Übertragung mittels einer Kapillareinrichtung (36)
auf die Metalloberfläche aufgebracht wird.

5. Verfahren nach Anspruch 4,
**dadurch gekennzeichnet,**
**dass** beim Eintsuchen in der wachsartigen Substanz (14) eine stehende Welle angeregt wird.

6. Verfahren nach einem der vorhergehenden Ansprüche,
**dadurch gekennzeichnet,**
**dass** die nicht galvanisch zu beschichtenden Oberflächenbereiche beim Aufbringen der wachsartigen Substanz (14) durch eine auf die Oberfläche aufgebrachte dünne Maske (40) aus Kunststoff oder Metall abgedeckt werden.

7. Verfahren nach Anspruch 6,
**dadurch gekennzeichnet,**
**dass** eine Kunststoff-Maske (40) aus Polyester oder Polyimid verwendet wird.

8. Verfahren nach einem der vorhergehenden Ansprüche,
**dadurch gekennzeichnet,**
**daß** die, aufzubringende wachsartige Substanz (14) und/oder das Dielektrikum (18) jeweils durch eine Heizeinrichtung (26) auf eine bestimmte Temperatur aufgeheizt werden.

9. Verfahren nach einem der vorhergehenden Ansprüche,
**dadurch gekennzeichnet,**
**dass** das Dielektrikum (18) durch Aufspritzen, Aufsprühen, Aufpinseln, Aufwalzen oder Eintauchen der Metalloberfläche aufgebracht wird.

10. Verfahren nach einem der vorhergehenden Ansprüche,
**dadurch gekennzeichnet,**
**dass** das Dielektrikum (18) selektiv oder vollflächig auf die Metalloberfläche aufgebracht wird.

11. Verfahren nach einem der vorhergehenden Ansprüche,
**dadurch gekennzeichnet,**
**daß** die wachsartige Substanz (14) mittels eines Wasserstrahls, insbesondere ein Hochdruckwasserstrahl (20), abgelöst wird.

12. Verfahren nach einem der vorhergehenden Ansprüche,
**dadurch gekennzeichnet,**
**dass** die wachsartige Substanz (14) beim Ablösen mit Ultraschall beaufschlagt wird.

13. Verfahren nach einem der vorhergehenden Ansprüche,
**dadurch gekennzeichnet,**
**dass** das Dielektrikum (18) nach dem galvanischen Beschichten in einer wässrigenalkalischen Lösung oder In einem Mikrophasenreiniger von der Metalloberfläche abgelöst wird.

14. Verfahren nach Anspruch 13,
**dadurch gekennzeichnet,**
**dass** das Dielektrikum (18) beim Ablösen mit Ultraschall oder in einem kavitationsfähigen Medium mit Kavitation beaufschlagt wird.

15. Galvanisches Selektiv-Beschichtungssystem für Metalloberflächen mit:
- einer Halte-/Führungseinrichtung für ein galvanisch zu beschichtendes Metall (10, 24, 30, 34, 38, 46, 48, 52);
- einer ersten Maskierungs- oder Beschichtungseinrichtung (12, 26, 28. 36, 40, 44, 50) zum selektiven Aufbringen einer schmelzflüssigen, wachsartigen Substanz (14) auf die galvanisch zu beschichtenden Oberflächenbereiche des zu beschichtenden Metalls (10, 24, 30, 34, 38, 46, 48, 52);
- einer zweiten Maskierungs- oder Beschichtungseinrichtung zum anschließenden Aufbringen eines flüssigen Dielektrikums (18) auf die nicht galvanisch zu beschichtenden Oberflächenbereiche des zu beschichtenden Metalls (10, 24, 30, 34, 38, 46, 48, 52);
- einer Wasser-Ablöseeinrichtung (20) zum Ablösen aufgebrachter wachsartiger Substanz (14);
- einer der Wasser-Ablöseeinrichtung (20) nachgeschaltete galvanische Beschichtungseinrichtung; und
- einer Steuerungseinrichtung.

16. Selektiv-Beschichtungssystem nach Anspruch 15,
**dadurch gekennzeichnet,**
**dass** die erste Maskierungs- oder Beschichtungseinrichtung (12, 26, 28, 36, 40, 44, 50) einen ersten Vorrats- oder Maskierungsbehälter (12), eine erste Spritz- (44), Sprüh- oder Pinseleinrichtung, einen Filz (50), eine erste Walzen- oder Rolleneinrichtung (28), eine Kapillareinrichtung (36) und/oder eine Maske (40) aus Kunststoff oder Metall umfasst.

17. Selektiv-Beschichtungssystem nach Anspruch 15 oder 16,
**dadurch gekennzeichnet,**
**dass** die zweite Maskierungs- oder Beschichtungseinrichtung einen zweiten Vorrats- oder Beschichtungsbehälter, eine zweite Spritz-, Sprüh- oder Pinseleinrichtung und/oder eine zweite Walzeneinrichtung umfasst.

18. Selektiv-Beschichtungssystem nach einem der Ansprüche 15 - 17,
**dadurch gekennzeichnet,**
**dass** die erste Maskierungs- oder Beschichtungseinrichtung (12, 26, 28, 36, 40, 44, 50) und/oder die zweite Maskierungs- oder Beschichtungseinrichtung zumindest je einen Temperatursensor und eine elektrische Heizeinrichtung (26) umfassen.

19. Selektiv-Beschichtungssystem nach einem der Ansprüche 15-18,
**dadurch gekennzeichnet,**
**dass** die Wasser-Ablöseeinrichtung eine Wasserstrahleinrichtung, insbesondere eine Hochdruck-Wasserstrahleinrichtung (20) oder eine erste Ultraschalleinrichtung umfasst.

20. Selektiv-Beschichtungssystem nach einem der Ansprüche 15-19,
**gekennzeichnet durch,**
eine zweite Ablöseeinrichtung zum Ablösen der dielektrischen Beschichtung.

21. Selektiv-Beschichtungssystem nach Anspruch 20,
**dadurch gekennzeichnet,**
**dass** die zweite Ablöseeinrichtung eine zweite Ultraschalleinrichtung oder eine zweite Kavitationseinrichtung mit einem kavitationsfähigen Medium umfasst.

22. Selektiv-Beschichtungssystem nach einem der Ansprüche 15 - 21,
**gekennzeichnet durch**,
zumindest eine Reinigungs-/Trocknungseinrichtung zum Reinigen und Trocknen der Metalloberfläche.

## Claims

1. Method for the selective galvanic coating of metal surfaces, comprising the following method steps:
- first selective masking of the surface regions that are to be galvanically coated, with a molten, waxy substance (14);
- second masking of the surface regions that are not to be galvanically coated, with a liquid dielectric (18) ;
- removal of the waxy substance (14), with water (20); and
- selective galvanic coating of the free surface regions.

2. Method according to Claim 1, **characterized in that** polyethyleneglycol, 1-hexadecanol, 1-octadecanol, a mixture of 1-hexadecanol and 1-octadecanol or a similar substance that can be removed by water is used as the waxy substance (14).

3. Method according to Claim 2, **characterized in that** polyethyleneglycol with an average molecular weight of 8000 - 12000 is used.

4. Method according to one of the preceding claims, **characterized in that** the molten waxy substance (14) is applied to the metal surface by:
- using capillary forces after bringing the metal surface into contact with this substance (14) or immersion in this substance (14);
- spraying or brushing on;
- immersion of the metal surface into this substance (14);
- transfer to the metal surface by means of at least one rotating roller (28);
- a felt (50); and/or
- transfer by means of a capillary device (36).

5. Method according to Claim 4, **characterized in that** immersion in the waxy substance (14) has the effect of inducing a standing wave.

6. Method according to one of the preceding claims, **characterized in that** the surface regions that are not to be galvanically coated are covered by a thin mask (40) of plastic or metal applied to the surface when the waxy substance (14) is applied.

7. Method according to Claim 6, **characterized in that** a plastic mask (40) of polyester or polyimide is used.

8. Method according to one of the preceding claims, **characterized in that** the waxy substance (14) and/or the dielectric (18) to be applied are respectively heated up to a certain temperature by a heating device (26).

9. Method according to one of the preceding claims, **characterized in that** the dielectric (18) is applied by spraying, brushing or rolling on or immersion of the metal surface.

10. Method according to one of the preceding claims, **characterized in that** the dielectric (18) is applied to the metal surface selectively or over its full surface area.

11. Method according to one of the preceding claims, **characterized in that** the waxy substance (14) is removed by means of a water jet, in particular a high-pressure water jet (20).

12. Method according to one of the preceding claims, **characterized in that**, during removal, the waxy substance (14) is exposed to ultrasound.

13. Method according to one of the preceding claims, **characterized in that**, after the galvanic coating, the dielectric (18) is removed from the metal surface in an aqueous-alkaline solution or in a microphase cleaner.

14. Method according to Claim 13, **characterized in that**, during removal, the dielectric (18) is exposed to ultrasound or to cavitation in a cavitatable medium.

15. Galvanic selective coating system for metal surfaces, comprising:
- a holding/guiding device for a metal to be galvanically coated (10, 24, 30, 34, 38, 46, 48, 52);
- a first masking or coating device (12, 26, 28, 36, 40, 44, 50) for selectively applying a molten, waxy substance (14) to the surface regions that are to be galvanically coated of the metal to be coated (10, 24, 30, 34, 38, 46, 48, 52);
- a second masking or coating device for subsequently applying a liquid dielectric (18) to the surface regions that are not to be galvanically coated of the metal to be coated (10, 24, 30, 34, 38, 46, 48, 52);
- a water removing device (20) for removing applied waxy substance (14) ;
- a galvanic coating device arranged downstream of the water removing device (20); and
- a control device.

16. Selective coating system according to Claim 15, **characterized in that** the first masking or coating device (12, 26, 28, 36, 40, 44, 50) comprises a first storing or masking container (12), a first spray device (44) or brush device, a felt (50), a first roller device (28), a capillary device (36) and/or a mask (40) of plastic or metal.

17. Selective coating system according to Claim 15 or 16, **characterized in that** the second masking or coating device comprises a second storing or coating container, a second spray or brush device and/or a second roller device.

18. Selective coating system according to one of Claims 15-17, **characterized in that** the first masking or coating device (12, 26, 28, 36, 40, 44, 50) and/or the second masking or coating device each comprise at least a temperature sensor and an electric heating device (36).

19. Selective coating system according to one of Claims 15-18, **characterized in that** the water removing device comprises a water jet device, in particular a high-pressure water jet device (20) or a first ultrasonic device.

20. Selective coating system according to one of Claims 15-19, **characterized by** a second removing device for removing the dielectric coating.

21. Selective coating system according to Claim 20, **characterized in that** the second removing device comprises a second ultrasonic device or a second cavitation device with a cavitatable medium.

22. Selective coating system according to one of Claims 15-21, **characterized by** at least one cleaning/drying device for cleaning and drying the metal surface.

## Revendications

1. Procédé de métallisation sélective de surfaces métalliques, lequel procédé présente les étapes suivantes :
- premier masquage sélectif à l'aide d'une substance (14) de type cire, liquide à l'état fondu, des parties de surface qui doivent être métallisées,
- deuxième masquage à l'aide d'un diélectrique liquide (18) des parties de surface qui ne doivent pas être métallisées,
- enlèvement de la substance (14) de type cire à l' aide d'eau (20) et
- métallisation sélective des parties libres de la surface.

2. Procédé selon la revendication 1, **caractérisé en ce que** comme substance (14) de type cire, on utilise du polyéthylène glycol, du 1-hexadécanol, du 1-octadécanol, un mélange de 1-hexadécanol et de 1-octadécanol ou une substance similaire apte à être enlevée à l'eau.

3. Procédé selon la revendication 2, **caractérisé en ce que** l'on utilise du polyéthylène glycol d'un poids moléculaire moyen compris entre 8 000 et 12 000.

4. Procédé selon l'une des revendications précédentes, **caractérisé en ce que** la substance (14) de type cire liquide à l'état fondu est appliquée sur la surface métallique par:
- exploitation des forces capillaires après mise en contact de la surface métallique avec cette substance (14) ou immersion dans cette substance (14),
- projection, pulvérisation ou application au pinceau,
- immersion de la surface métallique dans cette substance (14),
- transfert sur la surface métallique par au moins un cylindre ou rouleau (28) rotatif,
- recours à un feutre (50) et/ou
- transfert au moyen d'un dispositif capillaire (36).

5. Procédé selon la revendication 4, **caractérisé en ce qu'**une onde stationnaire est excitée lors de l'immersion dans la substance (14) de type cire.

6. Procédé selon l'une des revendications précédentes, **caractérisé en ce que** lors de l'application de la substance (14) de type cire, les parties de surface qui ne doivent pas être métallisées sont recouvertes par un mince masque (40) en matière synthétique ou en métal appliqué sur la surface.

7. Procédé selon la revendication 6, **caractérisé en ce que** l'on utilise un masque de matière synthétique (40) en polyester ou polyimide.

8. Procédé selon l'une des revendications précédentes, **caractérisé en ce que** la substance (14) de type cire à appliquer et/ou le diélectrique (18) sont tous deux chauffés par un dispositif de chauffage (26) à une température définie.

9. Procédé selon l'une des revendications précédentes, **caractérisé en ce que** le diélectrique (18) est appliqué par projection, pulvérisation, application au pinceau, application au rouleau ou immersion de la surface métallique.

10. Procédé selon l'une des revendications précédentes, **caractérisé en ce que** le diélectrique (18) est appliqué sélectivement ou sur toute la surface métallique.

11. Procédé selon l'une des revendications précédentes, **caractérisé en ce que** la substance (14) de type cire est enlevée au moyen d'un jet d'eau et en particulier un jet d'eau (20) à haute pression.

12. Procédé selon l'une des revendications précédentes, **caractérisé en ce que** des ultrasons sont appliqués sur la substance (14) de type cire lors de son enlèvement.

13. Procédé selon l'une des revendications précédentes, **caractérisé en ce qu'**après la métallisation, le diélectrique (18) est enlevé de la surface métallique dans une solution alcaline aqueuse ou dans un nettoyeur à microphases.

14. Procédé selon la revendication 13, **caractérisé en ce que**, lors de l'enlèvement des ultrasons ou une cavitation réalisée dans un fluide susceptible de caviter sont appliqués sur le diélectrique (18).

15. Système de métallisation sélective de surfaces métalliques, qui présente:
- un dispositif de maintien et de guidage d'un métal (10, 24, 30, 34, 38, 46, 48, 52) à métalliser,
- un premier dispositif (12, 26, 28, 36, 40, 44, 50) de masquage ou de revêtement destiné à appliquer sélectivement une substance (14) de type cire liquide à l'état fondu sur les parties de surface à métalliser du métal (10, 24, 30, 34, 38, 46, 48, 52) à revêtir,
- un deuxième dispositif de masquage ou de revêtement destiné à appliquer ensuite un diélectrique liquide (18) sur les parties de surface qui ne doivent pas être métallisées du métal (10, 24, 30, 34, 38, 46, 48, 52) à revêtir,
- un dispositif (20) d'enlèvement à l'eau destiné à enlever la substance (14) du type cire qui a été appliquée,
- un dispositif de métallisation raccordé en aval du dispositif (20) d'enlèvement à l'eau et
- un dispositif de commande.

16. Système de revêtement sélectif selon la revendication 15, **caractérisé en ce que** le premier dispositif (12, 26, 28, 36, 40, 44, 50) de masquage ou de revêtement comprend un premier récipient de réserve ou de masquage (12), un premier dispositif (44) de projection, de pulvérisation ou d'application au pinceau, un feutre (50), un premier dispositif (28) d'application au cylindre ou au rouleau, un dispositif capillaire (36) et/ou un masque (40) en matière synthétique ou en métal.

17. Système de revêtement sélectif selon la revendication 15 ou 16, **caractérisé en ce que** le deuxième dispositif de masquage ou de revêtement comprend un deuxième récipient de réserve ou de revêtement, un deuxième dispositif de projection, de pulvérisation ou d'application au pinceau et/ou un deuxième dispositif à cylindre.

18. Système de revêtement sélectif selon l'une des revendication 15 à 17, **caractérisé en ce que** le premier dispositif (12, 26, 28, 36, 40, 44, 50) de masquage ou de revêtement et/ou le deuxième dispositif de masquage ou de revêtement présentent tous deux au moins une sonde de température et un dispositif électrique de chauffage (26).

19. Système de revêtement sélectif selon l'une des revendications 15 à 18, **caractérisé en ce que** le dispositif d'enlèvement à l'eau comprend un dispositif de projection d'eau et en particulier un dispositif (20) de projection d'eau sous haute pression ou un premier dispositif à ultrasons.

20. Système de revêtement sélectif selon l'une des revendications 15 à 19, **caractérisé par** un deuxième dispositif d'enlèvement destiné à enlever le revêtement diélectrique.

21. Système de revêtement sélectif selon la revendication 20, **caractérisé en ce que** le deuxième dispositif d'enlèvement comprend un deuxième dispositif à ultrasons ou un deuxième dispositif de cavitation doté d'un fluide susceptible de caviter.

22. Système de revêtement sélectif selon l'une des revendications 15 à 21, **caractérisé par** au moins un dispositif de nettoyage / séchage destiné à nettoyer et sécher la surface métallique.
